# FASCICULE DE BREVET EUROPEEN

(11) **EP 3 014 655 B1**
(45) Date de publication et mention de la délivrance du brevet: **09.08.2017**
(21) Numéro de dépôt: 14735528.3
(22) Date de dépôt: 27.06.2014
(51) Int. Cl.: H01L 23/00, H01L 21/428, H01L 21/762

(54) **PROCÉDÉ DE TRANSFERT D'UNE COUCHE MINCE AVEC APPORT D'ÉNERGIE THERMIQUE À UNE ZONE FRAGILISÉE VIA UNE COUCHE INDUCTIVE**
VERFAHREN ZUR ÜBERTRAGUNG EINER DÜNNEN SCHICHT MIT ZUFUHR VON WÄRMEENERGIE IN EINER FRAGILEN ZONE ÜBER EINE INDUKTIVE SCHICHT
METHOD FOR TRANSFERRING A THIN LAYER WITH SUPPLY OF HEAT ENERGY TO A FRAGILE ZONE VIA AN INDUCTIVE LAYER

(30) Priorité: 27.06.2013 FR 1356213
(43) Date de publication de la demande: 04.05.2016
(73) Titulaire: Commissariat à l'Énergie Atomique et aux Énergies Alternatives, 75015 Paris (FR)
(72) Inventeur: SIGNAMARCHEIX, Thomas, 38240 MEYLAN FRANCE (FR); AUGENDRE, Emmanuel, F-38330 Montbonnot (FR); BENAISSA, Lamine, F-91300 Massy (FR)
(74) Mandataire: Brevalex
(86) Numéro de dépôt international: PCT/EP2014/063665
(87) Numéro de publication internationale: WO 2014/207184

(56) Documents cités:
- EP-A1- 2 468 931
- US-A1- 2009 179 160
- US-A1- 2013 156 989
- MORICEAU H ET AL: "Smart Cut<TM>: review on an attractive process for innovative substrate elaboration", NUCLEAR INSTRUMENTS & METHODS IN PHYSICS RESEARCH, SECTION B (BEAM INTERACTIONS WITH MATERIALS AND ATOMS) ELSEVIER SCIENCE B.V. NETHERLANDS, vol. 277, 15 avril 2012 (2012-04-15), pages 84-92, XP002721940, ISSN: 0168-583X, DOI: 10.1016/J.NIMB.2011.12.050

## Description

### DOMAINE TECHNIQUE

Le domaine de l'invention est celui de la réalisation de structures nécessitant un apport d'énergie thermique à un assemblage formé d'un premier substrat et d'un deuxième substrat qui présentent des coefficients de dilatation thermique différents.

L'invention concerne plus précisément le transfert d'une couche mince d'un premier substrat vers un deuxième substrat présentant un coefficient de dilatation thermique différent de celui du premier substrat, dans lequel de l'énergie thermique est apportée pour provoquer, en tout ou partie, la fracture du premier substrat au niveau d'une zone fragilisée.

### ÉTAT DE LA TECHNIQUE ANTÉRIEURE

La technologie Smart Cut™ est une technique bien connue pour permettre le report de films minces de matériaux par exemple semiconducteurs, ou tout au moins partiellement cristallins.

Dans ce processus de report de film mince, des espèces ioniques telles que l'hydrogène ou l'hélium sont implantées dans un substrat B afin d'y former une zone de fragilisation. Le substrat B est par la suite mis en contact avec un substrat A, par exemple par collage direct.

Le processus fait alors appel à une mise sous pression de défauts étendus générés lors de l'implantation, impliquant donc un apport énergétique au niveau des espèces implantées afin de permettre leur transformation en une phase gazeuse.

Cette énergie est d'ordinaire principalement apportée par un traitement thermique appliqué à l'ensemble de la structure formée du substrat implanté B et du substrat A sur lequel il est assemblé.

Dans le cas d'une hétérostructure (assemblage de deux substrats A, B possédant des propriétés physico-thermiques de nature différentes, notamment une différence de coefficient de dilatation thermique), l'application globale d'un budget thermique engendre un processus naturel de dilatation des deux substrats qui tend à s'opérer de manière différente puisque leurs coefficients de dilatation propres ne sont pas identiques.

Les substrats étant assemblés mais ne pouvant se dilater indépendamment, il en résulte la génération de contraintes fortes dans l'hétérostructure. Cette contrainte peut atteindre des niveaux extrêmement élevés et conduit très souvent à des déformations excessives, voire à la casse totale de l'hétérostructure, ne permettant pas d'obtenir la structure recherchée (substrat A avec film reporté depuis le substrat B).

Afin d'étendre l'utilisation de la technologie Smart Cut™ à des hétérostructures, il a été proposé (voir par exemple l'article de K.Diest et al. intitulé « Silver diffusion bonding and layer transfer of lithium niobate to silicon », Appl. Phys. Lett. 93, 092906 (2008)) d'effectuer l'assemblage des deux substrats à chaud par l'intermédiaire d'une couche de collage par diffusion afin de minimiser le saut de contrainte à la fracture. Il a également été proposé (voir l'article de Y.-B.Park et al. intitulé « Integration of Single-Crystal LiNbO3 Thin Film on Silicon by Laser Irradiation and Ion Implantation-Induced Layer Transfer", Advanced Materials, Volume 18, Issue 12, pages 1533-1536, June, 2006) d'effectuer l'apport énergétique aux espèces implantées au moyen d'une irradiation Laser, absorbée préférentiellement dans la zone implantée. Chacune de ces approches présente toutefois des inconvénients : l'assemblage à chaud rend le film transféré contraint à température ambiante tandis que le recuit laser, obtenu par balayage d'impulsions brèves, peut conduire à un endommagement cristallin ainsi qu'à une augmentation de la rugosité de surface du film transféré. Le document US2013/0156989 décrit un procédé de transfert où les différents substrats peuvent avoir des coefficients de dilatation thermique différents. La délamination le long d'une couche implantée est effectuée par traitement thermique au cours d'une opération de thermocompression. La diffusion thermique s'effectue depuis la surface libre des substrats en contact avec des plaques chauffantes. Un besoin demeure donc pour une méthode qui puisse permettre de réaliser le report de films minces, par exemple par Smart Cut™, à partir de substrats présentant des propriétés physico-thermiques différentes tout en limitant la dilatation thermique des matériaux et donc en évitant la déformation excessive voire la casse de l'hétérostructure.

### EXPOSÉ DE L'INVENTION

L'invention a pour objectif de répondre à ce besoin et propose à cet effet un procédé de transfert d'une couche mince d'un premier substrat présentant un premier coefficient de dilatation thermique vers un deuxième substrat présentant un deuxième coefficient de dilatation thermique différent du premier coefficient de dilatation thermique, le premier substrat comportant une zone fragilisée délimitant la couche mince et une partie massive du premier substrat, le procédé comprenant les étapes de :
- mise en contact du premier substrat et du deuxième substrat,
- fracture du premier substrat au niveau de la zone fragilisée comprenant un apport d'énergie thermique au niveau de la zone fragilisée,
caractérisé par :
- la fourniture, avant ladite mise en contact, d'au moins une couche intermédiaire en surface de l'un au moins des premier et deuxième substrats, l'au moins une couche intermédiaire présentant un échauffement par induction, lorsqu'elle est soumise à un champ électromagnétique, supérieur à celui du premier et du deuxième substrat, respectivement,
- la réalisation de la mise en contact avec l'au moins une couche intermédiaire intercalée entre le premier substrat et le deuxième substrat,
- la réalisation dudit apport d'énergie thermique au niveau de la zone fragilisée par application d'un champ électromagnétique à l'hétérostructure formée par la mise en contact du premier substrat et du deuxième substrat.

Certains aspects préférés mais non limitatifs de procédé sont les suivants :
- la couche intermédiaire est réalisée en un matériau qui présente une densité de puissance dissipée au moins 100 fois supérieure, de préférence au moins 1000 fois supérieure, à la densité de puissance dissipée dans le matériau du premier et du deuxième substrat, respectivement, lorsque lesdits matériaux de la couche intermédiaire et du premier et du deuxième substrats sont soumis à un champ électromagnétique ;
- l'apport d'énergie thermique au niveau de la zone fragilisée conduit à la fracture du premier substrat au niveau de la zone fragilisée ;
- l'apport d'énergie thermique au niveau de la zone fragilisée conduit à la fragilisation du premier substrat au niveau de la zone fragilisée, et le procédé comprend en outre un apport d'énergie mécanique et/ou thermique complémentaire pour aboutir à la fracture du premier substrat au niveau de la zone fragilisée ;
- au cours dudit apport d'énergie thermique, l'un au moins des premier et deuxième substrats est agencé sur un support de tranche contrôlé en température ;
- la mise en contact est un collage direct du premier substrat et du deuxième substrat ;
- la couche intermédiaire est fournie en surface du premier et du deuxième substrats, et le premier substrat est collé au deuxième substrat via la couche intermédiaire servant de couche de collage ;
- il comprend, avant la mise en contact, la formation d'une couche thermiquement isolante sur l'un au moins du premier substrat et du deuxième substrat de telle manière que suite à la mise en contact, la couche thermiquement isolante est intercalée entre la couche intermédiaire et le deuxième substrat ;
- la couche intermédiaire est une couche métallique, par exemple une couche de cuivre ;
- le premier substrat est en LiNbO3 et le deuxième substrat est en Si ;
- le champ électromagnétique appliqué à l'hétérostructure pour réaliser ledit apport d'énergie thermique à la zone fragilisée est un champ électromagnétique pulsé.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
- les figure 1a-1c illustrent de manière schématique les étapes d'un mode de réalisation possible du procédé selon l'invention ;
- la figure 2 illustre la diffusion thermique dans un exemple d'hétérostructure du procédé selon l'invention ;
- les figures 3a et 3b sont des schémas illustrant l'élévation de température en différents points d'un exemple d'hétérostructure du procédé selon l'invention.

### EXPOSÉ DÉTAILLÉ DE MODES DE RÉALISATION PARTICULIERS

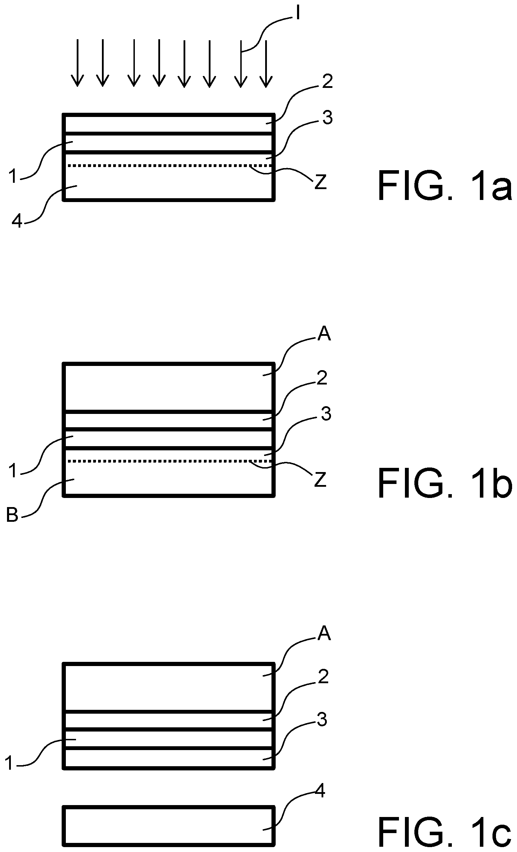

En référence aux figures 1a-1c, l'invention concerne un procédé de transfert d'une couche mince 3 d'un premier substrat B présentant un premier coefficient de dilatation thermique vers un deuxième substrat A présentant un deuxième coefficient de dilatation thermique différent du premier coefficient de dilatation thermique, typiquement d'au moins 10% ou 20% à température ambiante.

A titre d'exemple illustratif, l'invention porte sur le transfert d'une couche mince depuis un substrat en niobate de lithium sur un substrat de silicium. A température ambiante (20°C), le coefficient de dilatation thermique du silicium est de 3.10⁻⁶C⁻¹ tandis que celui du niobate de lithium est, selon l'axe considéré, de l'ordre de 5 à 7 fois celui du silicium.

Le procédé selon un mode de réalisation possible de l'invention comporte une première étape de fourniture d'au moins une couche intermédiaire en surface d'un au moins des premier et deuxième substrats. En référence à la figure 1a, la couche intermédiaire 1 est par exemple formée sur le premier substrat B.

La couche intermédiaire 1 peut être une couche déposée sur l'un et/ou l'autre des substrats A, B, par exemple par dépôt physique en phase vapeur (PVD pour *Physical Vapor Deposition*). L'épaisseur de la couche intermédiaire 1 est typiquement inférieure à 10 µm.

La couche intermédiaire 1 est une couche sensible aux sollicitations électromagnétiques, typiquement une couche métallique, par exemple une couche de cuivre. La couche intermédiaire présente ainsi un échauffement par induction lorsqu'elle est soumise à un champ magnétique supérieur à celui du premier et du deuxième substrat, respectivement.

La couche intermédiaire 1 est par exemple réalisée dans un matériau qui présente une densité de puissance dissipée (exprimée en W/m³) au moins 100 fois supérieure, de préférence au moins 1000 fois supérieure, à la densité de puissance dissipée dans le matériau du premier et du deuxième substrat, respectivement, lorsque lesdits matériaux de la couche intermédiaire et du premier et du deuxième substrats sont soumis à un même champ électromagnétique, en particulier à une même fréquence de travail.

A titre d'exemples de densités de puissance dissipées pour différents types de matériaux, on pourra se reporter au tableau en figure 4 de la demande de brevet US 2003/0164371 A1. En particulier, et à titre d'exemples purement illustratifs, la densité de puissance du silicium ou du germanium (avec un niveau de dopage de type n de l'ordre de 10¹⁵/cm³) est de l'ordre de 10 000 fois inférieure à celle de l'aluminium ou du cuivre. Ces matériaux conviennent ainsi parfaitement à la mise en oeuvre de l'invention.

Comme représenté sur la figure 1b, le procédé comporte une deuxième étape de mise en contact du premier substrat B et du deuxième substrat A avec l'au moins une couche intermédiaire 1 intercalée entre eux. La mise en contact peut notamment conduire à un collage direct des substrats, c'est-à-dire à un collage ne nécessitant pas d'apport de couche collante (de type colle, glue, etc.) et pouvant ou non comprendre un apport d'énergie thermique.

On obtient à l'issue de cette mise en contact une hétérostructure en ce sens que les deux substrats A, B possèdent des propriétés physico-thermiques différentes, notamment une différence de coefficient de dilatation thermique.

Dans un mode de réalisation possible représenté sur les figures 1a-1c, le procédé comprend avant la mise en contact des substrats A, B une étape de formation d'une couche thermiquement isolante 2 sur l'un au moins du premier substrat B et du deuxième substrat A de telle manière que suite à la mise en contact (voir figure 1b) la couche thermiquement isolante 2 est intercalée entre la couche intermédiaire 1 et le deuxième substrat A.

Comme représenté sur la figure 1a, la couche intermédiaire et la couche thermiquement isolante peuvent toutes deux être formées sur le premier substrat B. Une couche thermiquement isolante peut alors être également formée sur le deuxième substrat A. En variante, la couche thermiquement isolante et la couche intermédiaire peuvent être formées sur le deuxième substrat A. Ou encore, la couche intermédiaire peut être formée sur le premier substrat tandis que la couche thermiquement isolante est formée sur le deuxième substrat.

La couche thermiquement isolante est par exemple une couche de dioxyde de silicium SiO₂.

Le procédé comprend par ailleurs, avant la mise en contact, une étape de formation d'une zone fragilisée Z dans l'épaisseur du premier substrat B. La zone fragilisée délimite dans le premier substrat B une couche mince superficielle 3 et une partie massive 4. Comme représenté sur la figure 1a, la zone fragilisée Z peut être formée par implantation d'espèces I dans le premier substrat B. La zone fragilisée Z est située à une distance de la couche intermédiaire comprise entre 30 nm et 2 µm.

Suite à la mise en contact, le procédé comprend la réalisation d'un apport d'énergie au niveau de la zone fragilisée permettant la fracture du premier substrat B au niveau de la zone fragilisée, et en conséquence le transfert de la couche mince 3 du premier substrat B vers le deuxième substrat A comme représenté sur la figure 1c.

Le substrat composite (couche mince sur couche intermédiaire sur substrat A) obtenu après transfert peut être utilisé dans des applications radiofréquence où la couche intermédiaire métallique sert d'électrode métallique enterrée, ou encore dans des applications de puissance avec électrode métallique enterrée.

Contrairement aux procédés conventionnels dans lesquels cet apport d'énergie est réalisé, en tout ou partie, par un traitement thermique appliqué à l'ensemble de l'hétérostructure obtenue par la mise en contact, l'invention propose d'engendrer un échauffement indirect et localisé dans l'hétérostructure afin de conférer aux espèces implantées l'énergie nécessaire pour générer une phase gazeuse et ainsi accroitre la pression dans les microdéfauts issus de l'implantation sans affecter l'ensemble de la l'hétérostructure.

Ainsi, dans le cadre de l'invention, on réalise un tel apport d'énergie thermique par application d'un champ magnétique à l'hétérostructure formée par la mise en contact du premier substrat et du deuxième substrat, ladite application générant un échauffement par induction localisé au niveau de la couche intermédiaire qui induit une diffusion thermique vers la zone fragilisée, réalisant ainsi ledit apport d'énergie thermique au niveau de la zone fragilisée.

Le champ électromagnétique est typiquement appliqué au moyen d'une spire de courant entourant l'hétérostructure, par exemple une spire de cuivre, qui lorsqu'elle est parcourue par un courant électrique produit le champ électromagnétique qui va induire l'échauffement par induction localisé au niveau de la couche intermédiaire. La spire de courant peut notamment prendre la forme d'un tore ouvert, l'hétérostucture étant agencée au sein de l'ouverture du tore.

La couche intermédiaire sert ainsi de source de chaleur localisée, l'élévation maximale de température étant observée dans cette couche. Un gradient thermique est alors créé dans l'hétérostructure dont la valeur locale au niveau de la zone implantée permet l'activation du mécanisme de fracture. Ce gradient thermique permet d'allouer à la zone fragilisée tout ou partie du budget thermique nécessaire au phénomène de fracture tout en limitant l'élévation de température dans l'ensemble de l'hétérostructure. La dilatation thermique des substrats A, B est ainsi limitée, ce qui permet de limiter la déformation et d'éviter la casse de l'hétérostructure.

Dans un mode de réalisation, cet apport d'énergie thermique au niveau de la zone fragilisée par application d'un champ électromagnétique à l'hétérostructure conduit à la fracture du premier substrat au niveau de la zone fragilisée. Dans un autre mode de réalisation, cet apport d'énergie thermique conduit à la fragilisation du premier substrat au niveau de la zone fragilisée, et on procède à un apport d'énergie mécanique et/ou thermique complémentaire pour aboutir à la fracture du premier substrat au niveau de la zone fragilisée. Cet apport d'énergie complémentaire est de préférence réalisé suite à l'apport d'énergie thermique par induction.

On notera que lorsque la couche intermédiaire sert de couche de collage lors de l'étape de mise en contact (un couche intermédiaire étant pour cela préalablement formée sur chacun des premier et deuxième substrats), l'application du champ magnétique permet de renforcer le collage, non seulement du fait de l'effet thermique lié à l'échauffement de la couche intermédiaire, mais également par circulation des courants électriques induits qui viennent contribuer à la fermeture de l'interface de collage par électro-migration.

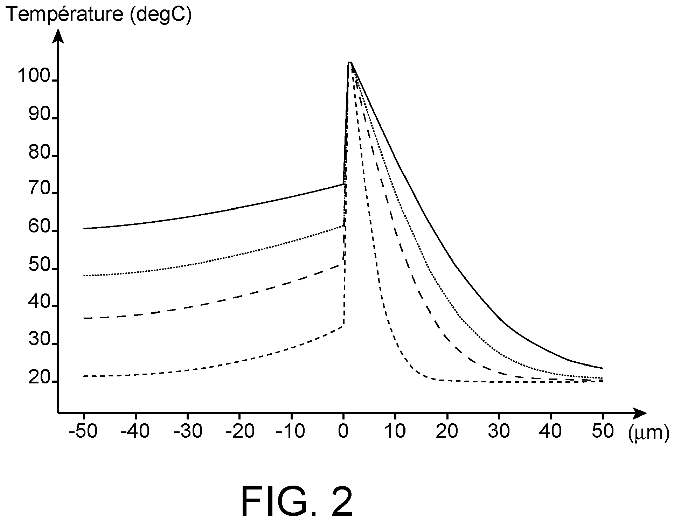

La présence d'une couche thermiquement isolante 2 s'avère avantageuse en ce que cette couche 2 favorise la diffusion thermique d'un seul côté de la couche intermédiaire 1, le gradient thermique généré par le phénomène d'induction prenant alors la forme d'un profil gaussien asymétrique. La figure 2, qui représente des résultats de simulation en régime stationnaire, fournit quatre exemples de ce type de diffusion asymétrique en fonction du degré d'échauffement généré dans la couche intermédiaire par diverses applications de champ magnétique. Sur cette figure 2, la position « 0 » sépare un substrat de Si (à gauche) d'une couche thermiquement isolante de SiO2 de 1 µm suivie d'une couche intermédiaire de cuivre puis d'un deuxième substrat B en niobate de lithium (à droite), l'axe des abscisses représentant l'écart à cette position « 0 » exprimé en micromètres.

Dans un mode de réalisation, au cours dudit apport d'énergie thermique par induction, l'un au moins des premier et deuxième substrats est agencé sur un support de tranche (ou « chuck » dans la terminologie anglo-saxonne consacrée) contrôlé en température, notamment pour venir refroidir la face arrière du premieret/ou du deuxième substrats et limiter ainsi l'élévation en température au sein du premier/et ou du deuxième substrats.

Dans un mode de réalisation, le champ magnétique auquel l'hétérostructure est soumise pour réaliser ledit apport d'énergie thermique à la couche fragilisée est un champ électromagnétique pulsé. Ceci permet d'augmenter le différentiel de température entre le voisinage de la zone fragilisée et le reste de l'hétérostructure, en particulier lorsque les substrats ne présentent pas la même constante de temps thermique, comme c'est par exemple le cas de substrats de silicium et de niobate de lithium.

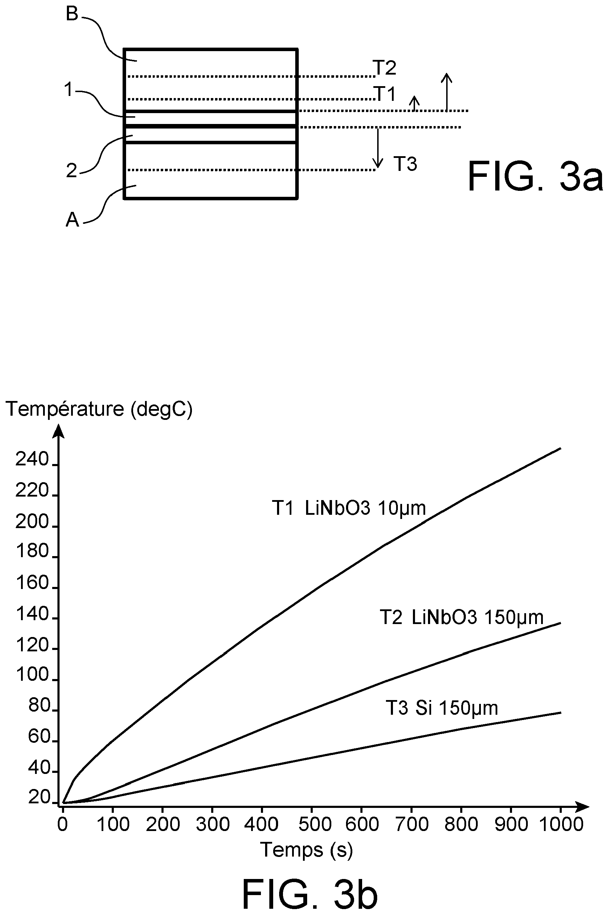

Les figures 3a et 3b sont des schémas illustrant l'élévation de température en différents points d'un exemple d'hétérostructure formée par l'assemblage d'un premier substrat B en niobate de lithium LiNbO3 de 250 µm d'épaisseur et de 50 mm de diamètre avec un deuxième substrat A en silicium Si de 250 µm d'épaisseur et de 50 mm de diamètre via une couche intermédiaire 1 de cuivre de 10 µm d'épaisseur et une couche thermiquement isolante 2 de SiO₂ de 10 µm d'épaisseur.

Le champ magnétique est appliqué dans l'environnement ambiant, au moyen d'une spire de cuivre avec refroidissement à l'eau, présentant un rayon de 5mm, avec une puissance de l'ordre de 7 kW, une intensité de 34 A et avec une fréquence 500 kHz.

La figure 3b illustre l'augmentation de température en fonction de la durée d'excitation électromagnétique en différents points de l'hétérostructure de la figure 3a : dans le premier substrat B à T1=10 µm de la couche intermédiaire 1 et à T2=150 µm de la couche intermédiaire, dans le deuxième substrat A à T3= 150 µm de la couche intermédiaire 1. On observe notamment qu'à environ 100 secondes d'excitation électromagnétique, la température à T2 et T3 n'excède pas 27°C alors que la température à T1 atteint les 60°C. L'écart de température est ainsi faible entre les deux substrats alors qu'on observe une augmentation de température relativement importante au voisinage de la couche intermédiaire.

La fracture d'un substrat de niobate de lithium implanté d'hélium à une dose de 10¹⁷/cm² est classiquement obtenue par un traitement thermique global à 70°C pendant quelques heures. La zone fragilisée se trouvant typiquement à 1 µm de la couche intermédiaire, l'augmentation importante de la température au voisinage de la couche intermédiaire obtenue dans le cadre de l'invention permet ainsi d'obtenir la fracture, étant rappelé que le phénomène de fracture suit une cinétique en loi d'Arrhenius dont l'énergie d'activation pour le niobate de lithium est estimée à 1.3 eV (fracture environ 1000 fois plus rapide tous les 70°C).

## Revendications

1. Procédé de transfert d'une couche mince (3) d'un premier substrat (B) présentant un premier coefficient de dilatation thermique vers un deuxième substrat (A) présentant un deuxième coefficient de dilatation thermique différent du premier coefficient de dilatation thermique, le premier substrat (B) comportant une zone fragilisée (Z) délimitant la couche mince (3) et une partie massive (4) du premier substrat, le procédé comprenant les étapes de :
- mise en contact du premier substrat (B) et du deuxième substrat (A),
- fracture du premier substrat au niveau de la zone fragilisée comprenant un apport d'énergie thermique au niveau de la zone fragilisée (Z),
- la fourniture, avant ladite mise en contact, d'au moins une couche intermédiaire (1) en surface de l'un au moins des premier et deuxième substrats, l'au moins une couche intermédiaire présentant un échauffement par induction, lorsqu'elle est soumise à un champ électromagnétique, supérieur à celui du premier et du deuxième substrat, respectivement,
- la réalisation de la mise en contact avec l'au moins une couche intermédiaire (1) intercalée entre le premier substrat (B) et le deuxième substrat (A),
- la génération, par application d'un champ électromagnétique à l'hétérostructure formée par la mise en contact du premier substrat (B) et du deuxième substrat (A), d'un échauffement par induction localisé au niveau de la couche intermédiaire (1), ledit échauffement localisé induisant une diffusion thermique vers la zone fragilisée et réalisant ainsi ledit apport d'énergie thermique au niveau de la zone fragilisée.

2. Procédé selon la revendication 1, dans lequel la couche intermédiaire est réalisée en un matériau qui présente une densité de puissance dissipée au moins 100 fois supérieure, de préférence au moins 1000 fois supérieure, à la densité de puissance dissipée dans le matériau du premier et du deuxième substrat, respectivement, lorsque lesdits matériaux de la couche intermédiaire et du premier et du deuxième substrats sont soumis à un champ électromagnétique.

3. Procédé selon l'une des revendications 1 à 2, dans lequel l'apport d'énergie thermique au niveau de la zone fragilisée par application d'un champ électromagnétique à l'hétérostructure conduit à la fracture du premier substrat au niveau de la zone fragilisée.

4. Procédé selon la revendication 1, dans lequel l'apport d'énergie thermique au niveau de la zone fragilisée par application d'un champ électromagnétique à l'hétérostructure conduit à la fragilisation du premier substrat au niveau de la zone fragilisée, comprenant en outre un apport d'énergie mécanique et/ou thermique complémentaire pour aboutir à la fracture du premier substrat au niveau de la zone fragilisée.

5. Procédé selon l'une des revendications 1 à 4, comprenant une étape de formation de la zone fragilisée (Z) par implantation d'espèces (I) dans l'épaisseur du premier substrat (B).

6. Procédé selon l'une des revendications 1 à 5, dans lequel au cours dudit apport d'énergie thermique, l'un au moins des premier et deuxième substrats est agencé sur un support de tranche contrôlé en température.

7. Procédé selon l'une des revendications 1 à 6, dans lequel la mise en contact est un collage direct du premier substrat et du deuxième substrat.

8. Procédé selon la revendication 7, dans lequel la couche intermédiaire est fournie en surface du premier et du deuxième substrats, et dans lequel le premier substrat est collé au deuxième substrat via la couche intermédiaire servant de couche de collage.

9. Procédé selon l'une des revendications 1 à 8, comprenant, avant la mise en contact, la formation d'une couche thermiquement isolante (2) sur l'un au moins du premier substrat et du deuxième substrat de telle manière que suite à la mise en contact, la couche thermiquement isolante (2) est intercalée entre la couche intermédiaire (1) et le deuxième substrat (A).

10. Procédé selon l'une des revendications 1 à 9, dans lequel la couche intermédiaire est une couche métallique, par exemple une couche de cuivre.

11. Procédé selon l'une des revendications 1 à 10, dans lequel le premier substrat (B) est en LiNbO3 et le deuxième substrat (A) est en Si.

12. Procédé selon l'une des revendications 1 à 11, dans lequel le champ électromagnétique appliqué à l'hétérostructure pour réaliser ledit apport d'énergie thermique à la zone fragilisée est un champ électromagnétique pulsé.

## Patentansprüche

1. Verfahren zum Übertragen einer dünnen Schicht (3) von einem ersten Substrat (B) mit einem ersten Wärmeausdehnungskoeffizienten auf ein zweites Substrat (A) mit einem zweiten Wärmeausdehnungskoeffizienten, der sich vom ersten Wärmeausdehnungskoeffizienten unterscheidet, wobei das erste Substrat (B) einen versprödeten Bereich (Z) enthält, der die dünne Schicht (3) von einem massiven Abschnitt (4) des ersten Substrats abgrenzt, wobei das Verfahren nachfolgende Schritte umfasst:
- Inkontaktbringen des ersten Substrats (B) und des zweiten Substrats (A),
- Brechen des ersten Substrats in Höhe des versprödeten Bereichs unter Eintrag von Wärmeenergie in Höhe des versprödeten Bereichs (Z),
- vor dem Inkontaktbringen Bereitstellen zumindest einer Zwischenschicht (1) an der Oberfläche von zumindest einem aus erstem und zweitem Substrat, wobei die zumindest eine Zwischenschicht eine Induktionserwärmung aufweist, wenn sie einem elektromagnetischen Feld ausgesetzt wird, das höher als das des ersten bzw. des zweiten Substrats ist,
- Durchführen der Kontaktierung mit der zumindest einen Zwischenschicht (1), die zwischen dem ersten Substrat (B) und dem zweiten Substrat (A) eingefügt ist,
- Erzeugen einer in Höhe der Zwischenschicht (1) lokal erfolgenden Induktionserwärmung durch Anwenden eines elektromagnetischen Feldes auf die Heterostruktur, die durch Inkontaktbringen des ersten Substrats (B) und des zweiten Substrats (A) gebildet wird, wobei die lokal erfolgende Erwärmung eine Wärmediffusion zum versprödeten Bereich hin bewirkt und somit den Wärmeenergieeintrag in Höhe des versprödeten Bereichs durchführt.

2. Verfahren nach Anspruch 1, wobei die Zwischenschicht aus einem Material hergestellt ist, das eine Verlustleistungsdichte aufweist, die zumindest 100 mal, vorzugsweise zumindest 1000 mal höher als die Verlustleistungsdichte im Material des ersten bzw. des zweiten Substrats ist, wenn die Materialien der Zwischenschicht und des ersten bzw. des zweiten Substrats einem elektromagnetischen Feld ausgesetzt werden.

3. Verfahren nach einem der Ansprüche 1 bis 2, wobei der Wärmeenergieeintrag in Höhe des versprödeten Bereichs durch Anwenden eines elektromagnetischen Feldes auf die Heterostruktur zum Bruch des ersten Substrats in Höhe des versprödeten Bereichs führt.

4. Verfahren nach Anspruch 1, wobei der Wärmeenergieeintrag in Höhe des versprödeten Bereichs durch Anwenden eines elektromagnetischen Feldes auf die Heterostruktur zur Versprödung des ersten Substrats in Höhe des versprödeten Bereichs führt, ferner umfassend einen zusätzlichen Eintrag von mechanischer und/oder thermischer Energie, um zum Bruch des ersten Substrats in Höhe des versprödeten Bereichs zu gelangen.

5. Verfahren nach einem der Ansprüche 1 bis 4, umfassend einen Schritt des Bildens des versprödeten Bereichs (Z) durch Implantieren von Spezies (I) in der Materialstärke des ersten Substrats (B).

6. Verfahren nach einem der Ansprüche 1 bis 5, wobei im Laufe des Wärmeenergieeintrags zumindest eines aus erstem und zweitem Substrat an einem temperaturgesteuerten Waferhalter angeordnet ist.

7. Verfahren nach einem der Ansprüche 1 bis 6, wobei das Inkontaktbringen ein direktes Bonden des ersten Substrats und des zweiten Substrats ist.

8. Verfahren nach Anspruch 7, wobei die Zwischenschicht an der Oberfläche des ersten und des zweiten Substrats bereitgestellt wird und wobei das erste Substrat mit dem zweiten Substrat über die als Bondschicht dienende Zwischenschicht gebondet wird.

9. Verfahren nach einem der Ansprüche 1 bis 8, umfassend vor dem Inkontaktbringen das Ausbilden einer thermisch isolierenden Schicht (2) an zumindest einem aus erstem Substrat und zweitem Substrat derart, dass nach dem Inkontaktbringen die thermisch isolierende Schicht (2) zwischen die Zwischenschicht (1) und das zweite Substrat (A) eingefügt wird.

10. Verfahren nach einem der Ansprüche 1 bis 9, wobei die Zwischenschicht eine Metallschicht, beispielsweise eine Kupferschicht, ist.

11. Verfahren nach einem der Ansprüche 1 bis 10, wobei das erste Substrat (B) aus LiNbO3 und das zweite Substrat (A) aus Si bestehen.

12. Verfahren nach einem der Ansprüche 1 bis 11, wobei das auf die Heterostruktur angewandte elektromagnetische Feld zum Erstellen des Wärmeenergieeintrags auf den versprödeten Bereich ein gepulstes elektromagnetisches Feld ist.

## Claims

1. Method of transferring a thin layer (3) from a first substrate (B) with a first coefficient of thermal expansion to a second substrate (A) with a second coefficient of thermal expansion different from the first coefficient of thermal expansion, the first substrate (B) comprising a weakened zone (Z) delimiting the thin layer (3) and a solid part (4) of the first substrate, the method comprising steps to:
- bring the first substrate (B) into contact with the second substrate (A),
- fracture the first substrate at the weakened zone making use of supply of thermal energy at the weakened zone (Z),
- provide at least one intermediate layer (1) to the surface of at least one of the first and second substrates before said contact is made, the temperature of the at least one intermediate layer being increased by induction when an electromagnetic field is applied to it, more than the temperature increase in the first and second substrates respectively,
- make the contact with the at least one intermediate layer (1) interposed between the first substrate (B) and the second substrate (A),
- generate induction heating located at the intermediate layer (1) by the application of an electromagnetic field to the heterostructure formed by the contact made between the first substrate (B) and the second substrate (A), said located heating inducing thermal diffusion towards the weakened zone, thus providing said supply of thermal energy at the weakened zone.

2. Method according to claim 1, in which the intermediate layer is made from a material that has a dissipated power density at least 100 times higher, and preferably at least 1000 higher, than the dissipated power density of the material of the first and the second substrates, respectively, when said materials in the intermediate layer and in the first and the second substrates are subjected to an electromagnetic field.

3. Method according to either claim 1 or 2, in which the supply of thermal energy at the weakened zone when an electromagnetic field is applied to the heterostructure leads to fracture of the first substrate at the weakened zone.

4. Method according to claim 1, in which the supply of thermal energy at the weakened zone by application of an electromagnetic field to the heterostructure leads to weakening of the first substrate at the weakened zone, and the method also includes an additional supply of mechanical and/or thermal energy to cause fracture of the first substrate at the weakened zone.

5. Method according to one of claims 1 to 4, comprising a step in which the weakened zone (Z) is formed by implantation of species (I) in the thickness of the first substrate (B).

6. Method according to one of claims 1 to 5, in which during said supply of thermal energy, at least one of the first and second substrates is disposed on a temperature controlled chuck.

7. Method according to one of claims 1 to 6, in which contact is made by direct bonding of the first substrate and the second substrate.

8. Method according to claim 7, in which the intermediate layer is provided on the surface of the first and the second substrates, and in which the first substrate is bonded to the second substrate through the intermediate layer acting as a bonding layer.

9. Method according to one of claims 1 to 8, in which before making contact, it includes formation of a thermal insulation layer (2) on at least either the first substrate or the second substrate such that after contact is made, the thermal insulation layer (2) is interposed between the intermediate layer (1) and the second substrate (A).

10. Method according to one of claims 1 to 9, in which the intermediate layer is a metal layer, for example a copper layer.

11. Method according to one of claims 1 to 10, in which the first substrate (B) is made from LiNbO3 and the second substrate (A) is made from Si.

12. Method according to one of claims 1 to 11, in which the electromagnetic field applied to the heterostructure to make said supply of thermal energy to the weakened zone is a pulsed electromagnetic field.
